# EUROPEAN PATENT SPECIFICATION

(11) **EP 2 139 264 B1**
(45) Date of publication and mention of the grant of the patent: **08.10.2014**
(21) Application number: 08712099.4
(22) Date of filing: 28.02.2008
(51) Int. Cl.: H03G 7/00, H03G 9/00, H03G 9/02

(54) **ACOUSTIC PROCESSING SYSTEM AND METHOD FOR ELECTRONIC DEVICE AND MOBILE TELEPHONE TERMINAL**
AKUSTISCHES VERARBEITUNGSSYSTEM UND VERFAHREN FÜR EIN ELEKTRONISCHES GERÄT UND MOBILTELEFON-ENDGERÄT
SYSTÈME DE TRAITEMENT ACOUSTIQUE ET PROCÉDÉ POUR DISPOSITIF ÉLECTRONIQUE ET TERMINAL DE TÉLÉPHONE MOBILE

(30) Priority: 20.03.2007 JP 2007073413
(43) Date of publication of application: 30.12.2009
(73) Proprietor: NEC Corporation, Minato-ku Tokyo 108-8001 (JP)
(72) Inventor: KURODA, Jun, Tokyo 108-8001 (JP); HOSOKAWA, Satoshi, Tokyo 108-8001 (JP); MORI, Ukyo, Tokyo 108-8001 (JP)
(74) Representative: Betten & Resch
(86) International application number: PCT/JP2008/053528
(87) International publication number: WO 2008/126496

(56) References cited:
- WO-A1-2005/086525
- JP-A- 9 232 896
- JP-A- 05 145 991
- JP-A- 06 177 688
- JP-A- 09 232 896
- US-A- 4 241 266
- US-A- 4 944 018
- US-A1- 2006 098 827

## Description

### Technical Field

The present invention relates to an acoustic processing system for electronic apparatuses such as a mobile telephone. The present invention in particular relates to an acoustic processing system and a method for an electronic apparatus and a mobile telephone terminal for enhancing a sound pressure and feeling of a sound volume in a reproduced sound as a whole. Note that the present application claims priority based on Japanese Patent Application No. 2007-073413

### Background Art

As an audio device internally installed in electronic apparatuses exemplified by mobile telephones, micro-speakers and micro-receivers with a diameter of about several centimeters and a thickness of about several millimeters are often mounted therein from a viewpoint of the mounting space and power consumption. However, in such micro-speakers with a limited size, the physical restrictions such as an acoustic radiating area, a front airtight volume, a rear airtight volume and a sound hole area are set with implementation conditions on the electric apparatuses. Therefore, micro-speakers are inferior to usual home and professional-use audio speakers in an equivalent noise level, flattening of sound pressure frequency characteristics, and a low-frequency reproducing function.

In recent years, the audio reproducing function in electronic apparatuses such as a mobile telephone becomes more important from a viewpoint of a marketability. On the other hand, it is also required for the sizes of acoustic devices to be smaller and thinner for corresponding to terminals whose size and thickness has been reduced. However, it is not easy to achieve a good balance between improvement of a reproducing function and device miniaturization. In particular, by miniaturizing an acoustic device, reproduction characteristics in low frequency is extremely deteriorated caused by the decrease of the radiating area, the front volume and the back volume. Therefore, when a low frequency signal is inputted to the acoustic device, the sound is distorted and the sound crack increases. It is therefore required to cut the input of a low frequency signal, but cutting off a low frequency signal causes reduction of a sound pressure and feeling of a sound volume in reproduced sound as a whole.

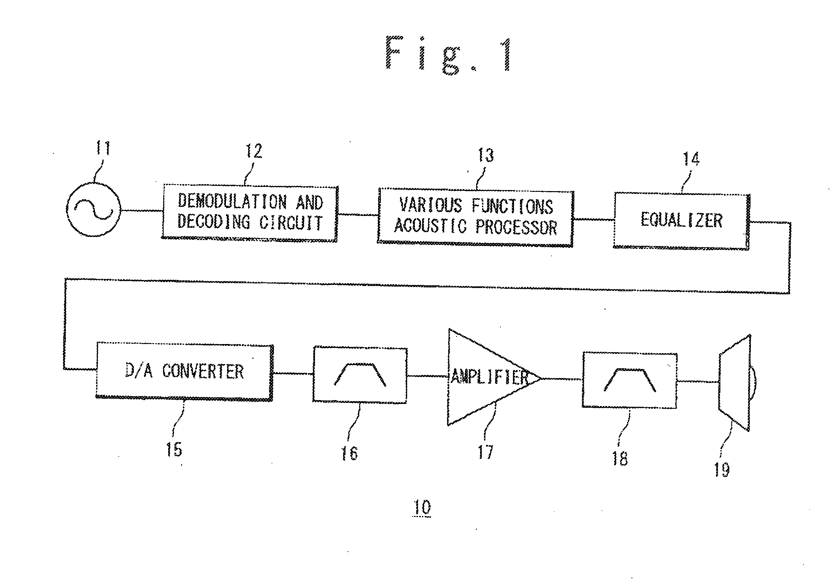

Fig. 1 is a diagram for explaining an example of signal processing in an audio path to be reproduced by a micro-speaker arranged inside an electronic apparatus in order to solve the above problems.

As shown in Fig. 1, an electronic apparatus 10 includes an audio digital sound source 11, a demodulation and decoding circuit 12, a various functions acoustic processor 13, an equalizer processor 14, a D/A (digital/analog) converter 15, a band-pass filter 16, an amplifier 17, a band-pass filter 18, and a micro-speaker 19. The demodulation and decoding circuit 12 demodulates and decodes a signal sent from the audio digital sound source 11 so as to convert a signal format. The various functions acoustic processor 13 carries out acoustic processes such as a 3D effect, a reverberation effect, a chorus effect, a delay effect, an enhance effect, a frequency band boost effect with respect to the signal sent from the demodulation and decoding circuit 12. The equalizer processor 14 boosts and cuts off each frequency for the signal which was subjected to acoustic processes. The D/A converter 15 converts the digital signal sent from the equalizer processor 14 into an analog signal. The band-pass filter 16 carries out a low frequency cut, a harmonic cut and a noise cut with respect to the converted analog signal. The amplifier 17 amplifies the signal sent from the band-pass filter 16. The band-pass filter 18 is arranged as needed so as to carry out a low frequency cut, a harmonic cut and a noise cut with respect to the signal which was amplified by the amplifier 17. The micro-speaker 19 is connected to the band-pass filter 18 so as to convert an electric signal into a sound to output.

Eachblockof the demodulation and decoding circuit 12, the acoustic processor 13, and the equalizer processor 14 can be realized by a DSP (digital signal processor) or can be realized by an individual dedicated LSI (large scale integrated circuit). Other components can also be integrated from each other in one LSI chip or a module by using a DSP, or can be configured by an individual LSI or IC (integrated circuit).

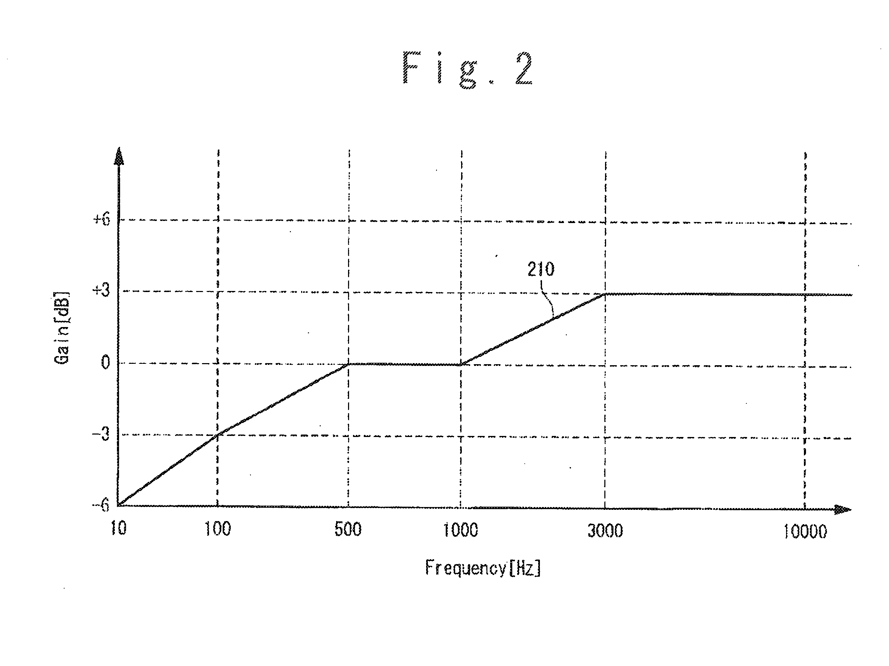

Fig. 2 shows an example of setting of the equalizer processor 14 in Fig. 1. Referring to Fig. 2, an example of setting of the equalizer processor 14 is shown by a line 210. In the present setting example, the equalizer processor 14 is set to cut low frequency signals equal to or less than 500 Hz by 6 dB at maximum in order to reduce a sound crack caused by a low frequency signal and adjust signals equal to or more than 3 kHz to 3 dB at maximum in order to enhance a sound pressure and feeling of a sound volume in an entire band. Such setting realizes adjustment of an input signal in any signal levels so that a signal level in an audio path which is present in the equalizer processor 14 and the following components does not go beyond a digital and/or analog full scale (i.e. 0 dB).

However, in the present example, a boost amount in a high frequency signal needs to be designed under the consideration of a margin for a digital/analog full scale of a full band signal. Therefore, the boost amount in a high frequency signal is limited to a narrow range. Accordingly, it is required to improve a sound pressure and feeling of a sound volume as a whole in micro-speakers and micro-receivers with low capacity of reproducing low-frequency characteristics.

For example, Japanese Laid-Open Patent Application JP-P2004-112414A discloses a technique for relatively accentuating a low frequency component to render the boldness of the sound by controlling a high frequency component of an input audio signal to be further attenuated in accordance with a larger amplitude compression amount.

Japanese Laid-Open Patent Application JP-P2004-248298A also discloses a technique regarding a hearing aid including a compressor having a fine delay which is independent of a gain with low power consumption. According to the hearing aid disclosed in Japanese Laid-Open Patent Application JP-P2004-248298A, a multi-channel compressor for compensating the loss of a hearing sense in a dynamic range is used to improve capacity of reproducing low frequency characteristics.

However, the techniques disclosed in Japanese Laid-Open Patent Applications JP-P2004-112414A and JP-P2004-248298A are provided without carrying out an acoustic process to improve a sound pressure and feeling of a sound volume as a whole.

### Disclosure of Invention

Accordingly, an object of the present invention is to provide an electronic apparatus acoustic processing system and an electronic apparatus acoustic processing method, wherein a sound process for improving a sound pressure and feeling of a sound volume as a whole is carried out by attenuating a low frequency and substantially enhancing an average sound pressure in a high frequency.

In order to solve the problems, the present invention provides an electronic apparatus acoustic processing system for outputting sound by demodulating and decoding a signal sent from an audio digital sound source and carrying out various kinds of acoustic processes for the signal which converts a signal format.

According to the present invention, an acoustic processing system for an electronic apparatus includes: an equalizer processor configured to boost or cut a digital signal being acoustically processed for each of frequency components; a low-pass filter configured to extract and output a signal of low frequency from the signal outputted from the equalizer processor; a high-pass filter configured to extract and output a signal of high frequency from a signal outputted from the equalizer processor; a high frequency compressor configured to compress the signal of high frequency; an adder configured to generate an addition of the signal of low frequency and the compressed signal of high frequency; and a speaker configure to output a sound in accordance with the addition signal.

According to the present invention, an acoustic processing method for an electronic apparatus includes: a step of boosting or cutting a digital signal being acoustically processed for each of frequency components; a step of extracting and outputting a signal of low frequency from the boosted or cut signal; a step of extracting and outputting a signal of a high frequency from the boosted or cut signal; a step of compressing the signal of high frequency; a step of generating an addition of the signal of low frequency and the compressed signal of high frequency; and a step of outputting a sound in accordance with the addition signal.

It is also preferable that an acoustic processing device for an electronic apparatus according to the present invention is mounted on a mobile telephone terminal.

As explained above, even if a high frequency signal is boosted to be larger by the equalizer processor, the present invention realizes compression of a dynamic range through suppression of only an excessive peak of a boosted high frequency signal by a high frequency compressor. It is therefore made possible to enhance the average value of the output signal level in comparison with an input signal in a time domain and improve an executed sound pressure without changing a voltage peak inputted to a micro-speaker. Furthermore, a sound is generated by the signal obtained by adding a low frequency signal and a high frequency signal which was compressed by a high frequency compressor. Therefore, feeling of a sound volume is substantially improved with improvement of an executed sound pressure.

### Brief Description of Drawings

The above object, effects and characteristics of the present invention will be identified more clearly from descriptions of exemplary embodiments in conjunction with accompanying diagrams, in which:
Fig. 1 is a diagram to explain an example of signal processing in an audio path to be reproduced by a micro-speaker arranged inside an electronic apparatus according to a conventional technique;
Fig. 2 is a diagram showing an example of setting of an equalizer processor according to a conventional technique;
Fig. 3 is a block diagram showing a schematic configuration of an electronic apparatus acoustic processing system according to an exemplary embodiment of the present invention;
Fig. 4 is a diagram showing an example of setting of an equalizer processor according to the present invention;
Fig. 5 is a diagram showing frequency characteristics of input/output signals in an electronic apparatus acoustic processing system according to the present invention;
Fig. 6 is a diagram showing characteristic of an electronic apparatus acoustic processing system according to the present invention in a time domain;
Fig. 7 is a block diagram showing a.schematic configuration of a first modified example in an electronic apparatus acoustic processing system according to an exemplary embodiment of the present invention;
Fig. 8 is a block diagram showing a schematic configuration of a second modified example in an electronic apparatus acoustic processing system according to an exemplary embodiment of the present invention;
Fig. 9 is a block diagram showing a schematic configuration of a third modified example in an electronic apparatus acoustic processing system according to an exemplary embodiment of the present invention;
Fig. 10 is a block diagram showing a schematic configuration of a fourth modified example in an electronic apparatus acoustic processing system according to an exemplary embodiment of the present invention;
Fig. 11 is a block diagram showing a schematic configuration of a fifth modified example in an electronic apparatus acoustic processing system according to an exemplary embodiment of the present invention;
Fig. 12 is a block diagram showing a schematic configuration of a sixth modified example in an electronic apparatus acoustic processing system according to an exemplary embodiment of the present invention; and
Fig. 13 is a block diagram showing a schematic configuration of a seventh modified example in an electronic apparatus acoustic processing system according to an exemplary embodiment of the present invention.

### Best Mode for Carrying Out the Invention

Exemplary embodiments of the electronic apparatus acoustic processing system according to the present invention will be explainedbelow referring to accompanying drawings. Identical or similar reference numbers refer to identical, similar or equivalent elements in the drawings.

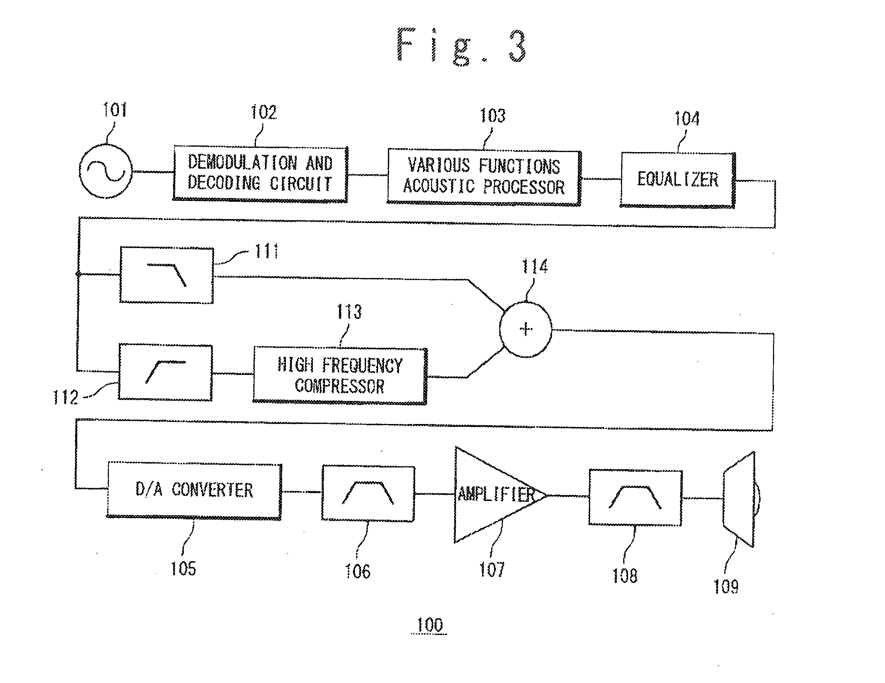

Fig. 3 is a block diagram showing a schematic configuration of an electronic apparatus acoustic processing system according to the present invention. The electronic apparatus acoustic processing system shown in Fig. 3 is preferably incorporated in a mobile telephone terminal. An electronic apparatus acoustic processing system 100 includes an audio digital sound source 101, a demodulation and decoding circuit 102, a various functions acoustic processor 103, an equalizer processor 104, a low-pass filter 111, a high-pass filter 112, a high frequency compressor 113, an adder 114, a D/A (digital/analog) converter 105, a band-pass filter 106, an amplifier 107, a band-pass filter 108 and a micro-speaker 109.

The demodulation and decoding circuit 102 demodulates and decodes a signal sent from the audio digital sound source 101 so as to convert the signal format. The various functions acoustic processor 103 carries out acoustic processes including a 3D effect, a reverberation effect, a chorus effect, a delay effect, an enhance effect and a frequency band boost effect with respect to the signal sent from the demodulation and decoding circuit 102. The equalizer processor 104 carries out a boosting and/or cut process for each frequency of the signal which was subjected to an acoustic process. The low-pass filter 111 extracts a low frequency component of an output of the equalizer processor to output as a low frequency signal. The high-pass filter 112 extracts a high frequency component of an output of the equalizer processor to output as a high frequency signal. The high frequency compressor 113 compresses the high frequency signal boosted by the equalizer processor 104. The adder 114 adds the low frequency signal and the compressed high frequency signal. The D/A converter 105 converts the digital signal, which was obtained by adding signals in the adder 114, into an analog signal. The band-pass filter 106 carries out a low frequency cut, a harmonic cut and a noise cut with respect to the converted analog signal. The amplifier 107 amplifies a signal sent from the band-pass filter 106. The band-pass filter 108 is arranged as needed so as to carry out a low frequency cut, a harmonic cut and a noise cut with respect to the signal amplified by the amplifier 107. The micro-speaker 109 converts an electric signal sent from the band-pass filter 108 into a sound to output.

Each block of the demodulation and decoding circuit 102, the acoustic processor 103 and the equalizer processor 104 can be realized by a DSP (digital signal processor) or can be realized by an individual dedicated LSI (large scale integrated circuit). Other components can also be integrated from each other in one LSI chip or a module by using DSP, or can be configured by an individual LSI or IC (integrated circuit).

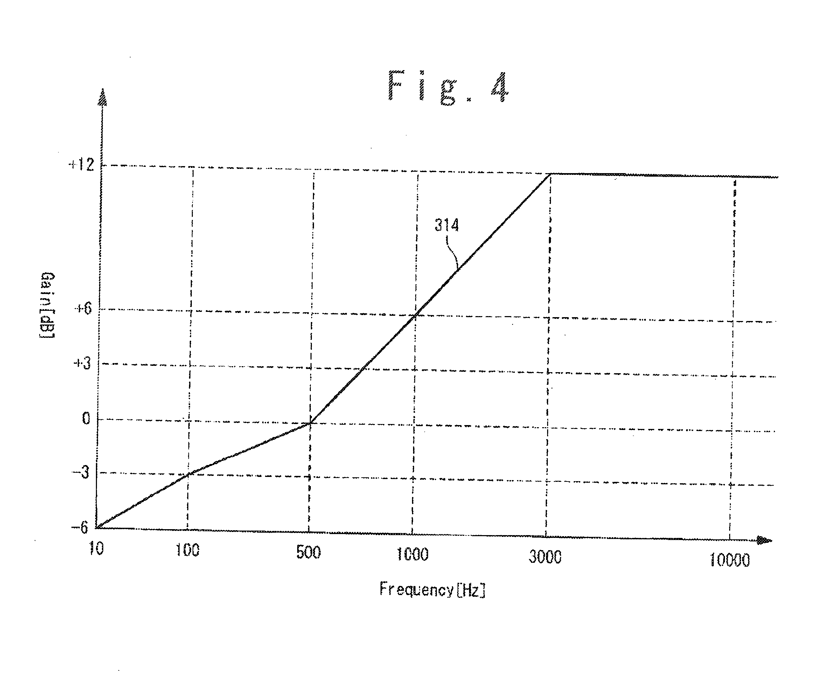

The cut-off frequency of each of the low pass filter 111 and the high-pass filter 112 may be determined under the consideration of a frequency boosted by each equalizer processor 104. In the case of the setting of the equalizer processor 104 shown in Fig. 4 described later, 1 kHz may be set for the cut-off frequency reduced by 3 dB.

Parameters of the high frequency compressor 113 include a threshold level, a ratio, an attack time and a release time or the like, each of which can be tuned based on a sound or other factors. For example, as the parameters of the high frequency compressor, a threshold level of -5 to -15 dB, a ratio of 1:4 to 1:8, an attack time of 0 to 25 msec, and a release time of 0 to 50 msec are set. By inserting the high frequency compressor 113 with such setting, it is possible for the equalizer processor 104 to boost a frequency higher than that of conventional techniques.

Fig. 4 shows an example of setting of the equalizer processor 104 shown in Fig. 3. For example, as shown by a line 314 in Fig. 4, the equalizer processor 104 is set to cut frequencies equal to or less than 500 Hz by 6 dB at maximum and boost a middle frequency and a high frequencies equal to or more than 500 Hz to 12 dB at maximum. Each of the low-pass filter 111 and the high-pass filter 112 is set to, for example, 1 kHz as a 3 dB cut off frequency.

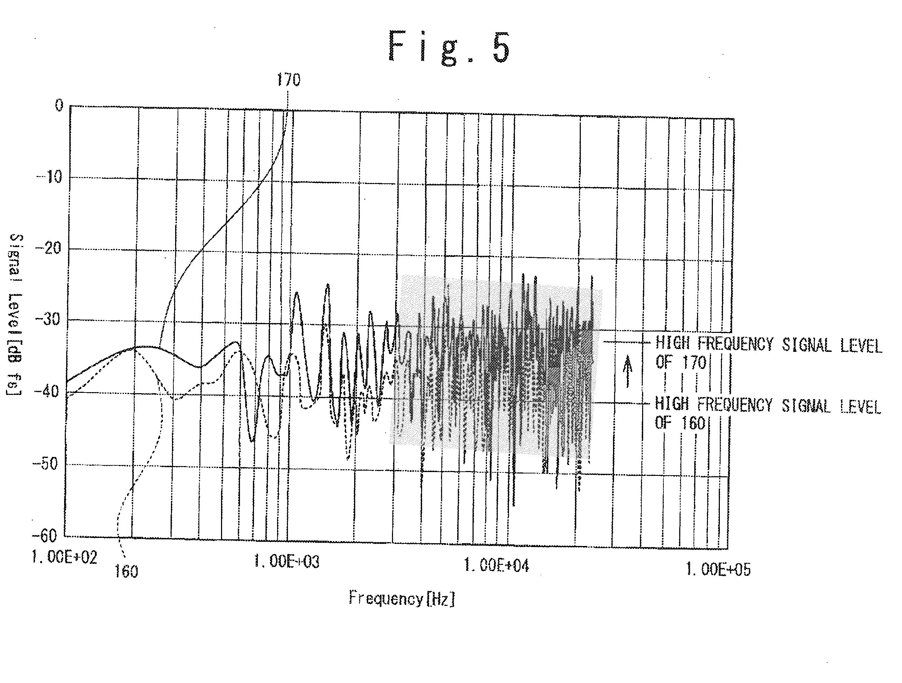

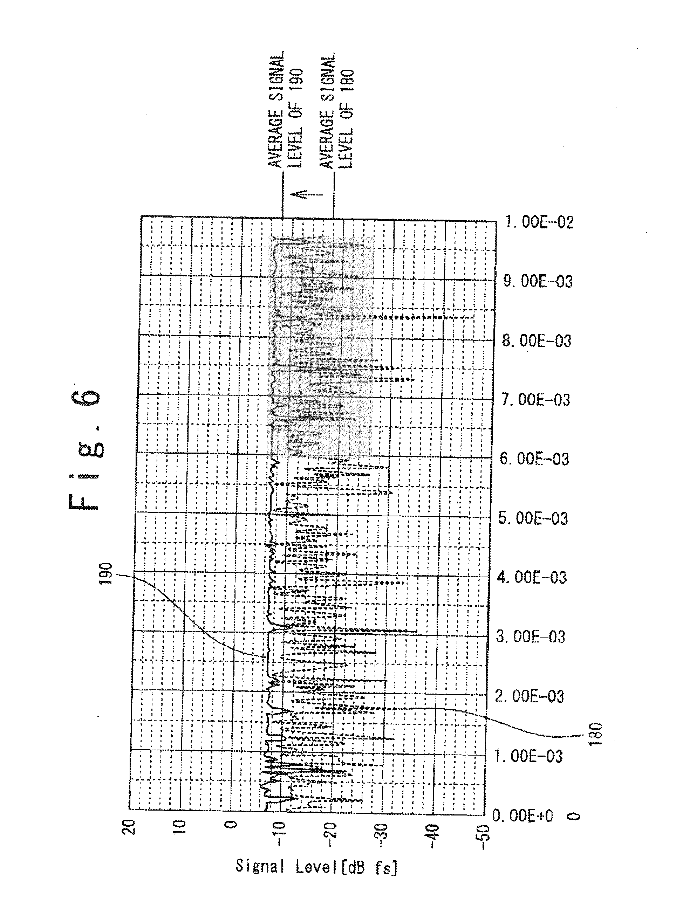

Fig. 5 shows a frequency characteristic 160 of an input signal and a frequency characteristic 170 of an output signal in the electronic apparatus acoustic processing system 100 which was set as stated above. Fig. 6 also shows a time characteristic 180 of an input signal and that of an output signal in the electronic apparatus acoustic processing system 100 which was set as stated above.

Figs. 5 and 6 show input/output characteristics of the electronic apparatus acoustic processing system 100 when white noise of 20 Hz to 24 kHz is inputted from the audio digital sound source 101. Note that the demodulation and decoding circuit 102 and the various functions acoustic processor 103 do not carry out any process which affects a frequency characteristic and a dynamic range in this case.

Referring to Fig. 5, the signal level of the high frequency signal in the output signal is boosted substantially at 6 dB or higher from the signal level of the high frequency signal in the input signal in the frequency region. In contrast, referring to Fig. 6, the signal level of the output signal exhibits a suppressed peak, while the average value of the signal level of the output signal is substantially enhanced in comparison with the average value of the signal level of the input signal in the time domain. That is, only an excessive peak of the high frequency signal boosted by the equalizer processor 104 is suppressed by the high frequency compressor 113 so as to compress the dynamic range. The average level of an output signal in the time domain is therefore enhanced along with enhancement of an executed acoustic pressure without changing the voltage peak inputted to the micro-speaker 109. Furthermore, according to the present invention, a sound is generated by a signal which is obtained by adding a low frequency signal to a high frequency signal compressed by the high frequency compressor 113. Therefore, feeling of the sound volume is enhanced substantially with the enhancement of the executed sound pressure.

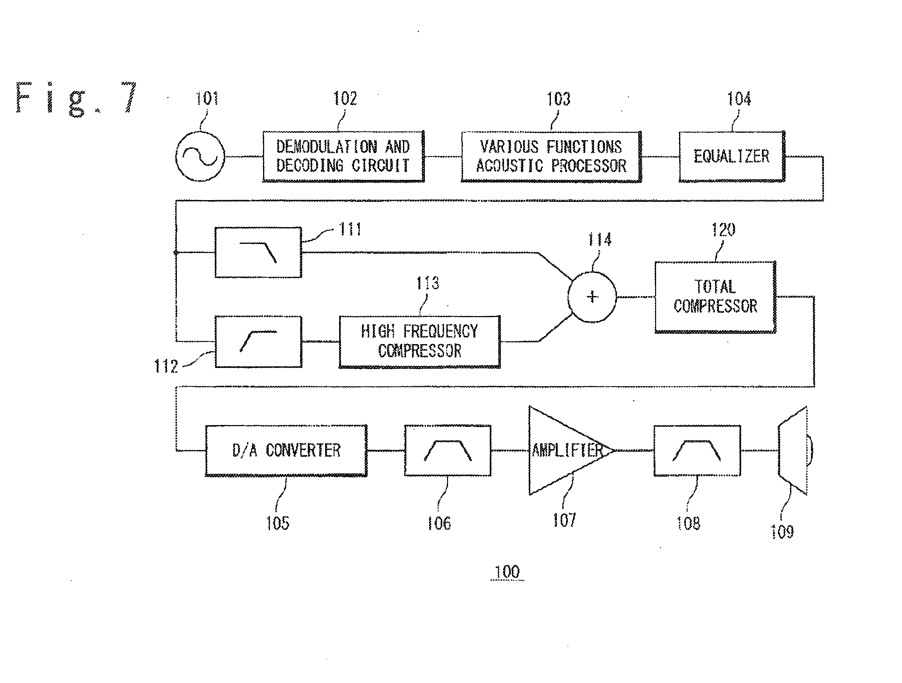

Fig. 7 is a block diagram showing a schematic configuration of a first modified example in the electronic apparatus acoustic processing system 100 shown in Fig. 3. Referring to Fig. 7, the first modified example of the electronic apparatus acoustic processing system 100 has a total compressor 120 inserted between the adder 114 and the D/A converter 105. The remaining configuration is the same as that shown in Fig. 3.

The total compressor 120 compresses a signal added in the adder 114 (i.e. added signal) so as to output to the D/A converter 105. The total compressor 120 makes it possible to suppress the peak level of a signal for whole of the frequency band of the input signal. As a result, compression of the dynamic range and enhancement of the executed sound pressure and the feeling of the sound volume can be achieved.

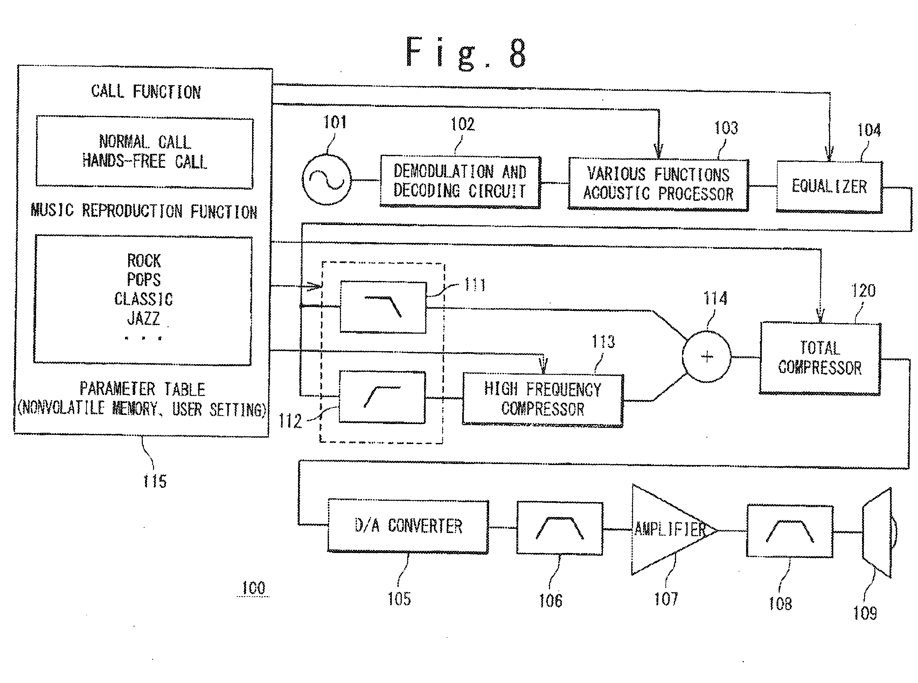

Fig. 8 is a block diagram showing a schematic configuration of a second modified example in the electronic apparatus acoustic processing system 100 shown in Fig. 3. Referring to Fig. 8, in the second modified example, the electronic apparatus acoustic processing system 100 has a total compressor 120 inserted between the adder 114 and the D/A converter 105, and moreover, a parameter table 115 is arranged. The remaining configuration is the same as that shown in Fig. 3.

The parameter table 115 stores parameters for the equalizer processor 104, the high frequency compressor 113, the various functions acoustic processor 103, the total compressor 120, the low-pass filter 111, the high-pass filter 112 or other components in accordance with each function. The parameter table 115 is preferably recorded in, for example, a nonvolatile memory. Parameters set in the parameter table 115 may also be desirably set (or changed) by a user. In this case, it is possible for a user to carry out acoustic setting in accordance with a preference of the user at any time.

For example, in a case of a mobile telephone, parameters are set according to each function such as a call function (i.e. normal and hands-free call) and a music reproducing function (i. e. music category setting such as the rock and the classic). In this case, each of the various functions acoustic processor 103, the equalizer processor 104, the low-pass filter 111, the high-pass filter 112, the high frequency compressor 113 and the total compressor 120 in Fig. 8 is subjected to parameters read from the parameter table 115 and therefore has operation states changed appropriately in accordance with each function. For example, an executed sound pressure and a sound volume are set to be larger in the music reproducing function than the normal call function.

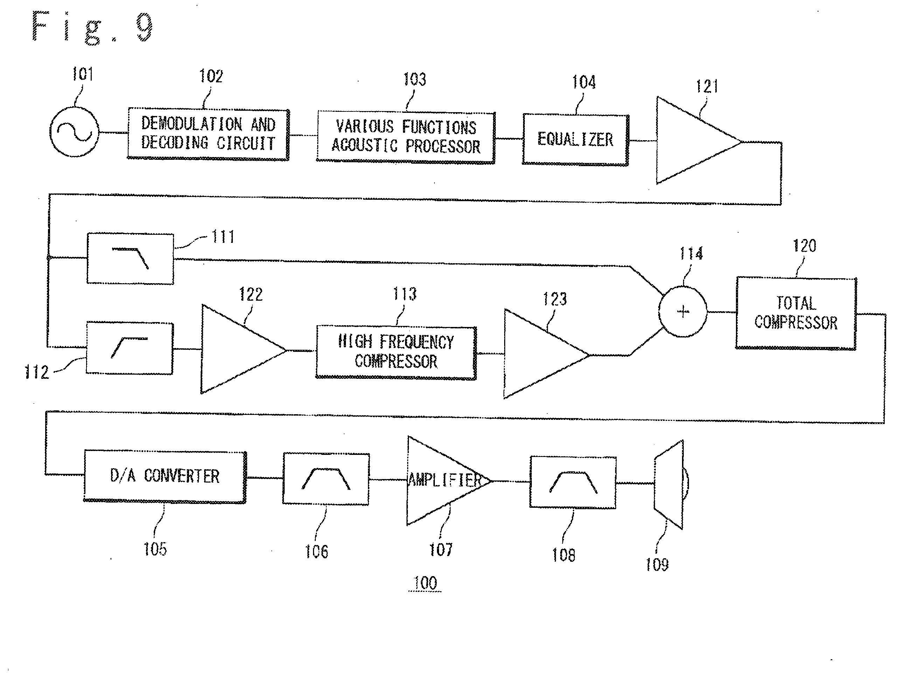

Fig. 9 is a block diagram showing a schematic configuration of a third modified example in the electronic apparatus acoustic processing system 100 shown in Fig. 3. Referring to Fig. 9, in the third modified example, the electronic apparatus acoustic processing system 100 includes a total compressor 120 inserted between the adder 114 and the D/A converter 105, and moreover, pre-gain amplifiers 121 and 122 and a host gain amplifier 123 are arranged. The pre-gain amplifier 121 is inserted between the equalizer processor 104 and the low-pass filer 111 as well as the high-pass filter 112. The pre-gain amplifier 122 is inserted between the high-pass filter 112 and the high frequency compressor 113. The host gain amplifier 123 is inserted between the high frequency compressor 113 and the adder 114. The remaining configuration is the same as that shown in Fig. 3.

By inserting the pre-gain amplifier 121, the pre-gain amplifier 122 and the host gain amplifier 123, it is possible to set the frequency gain without using the equalizer processor 104.

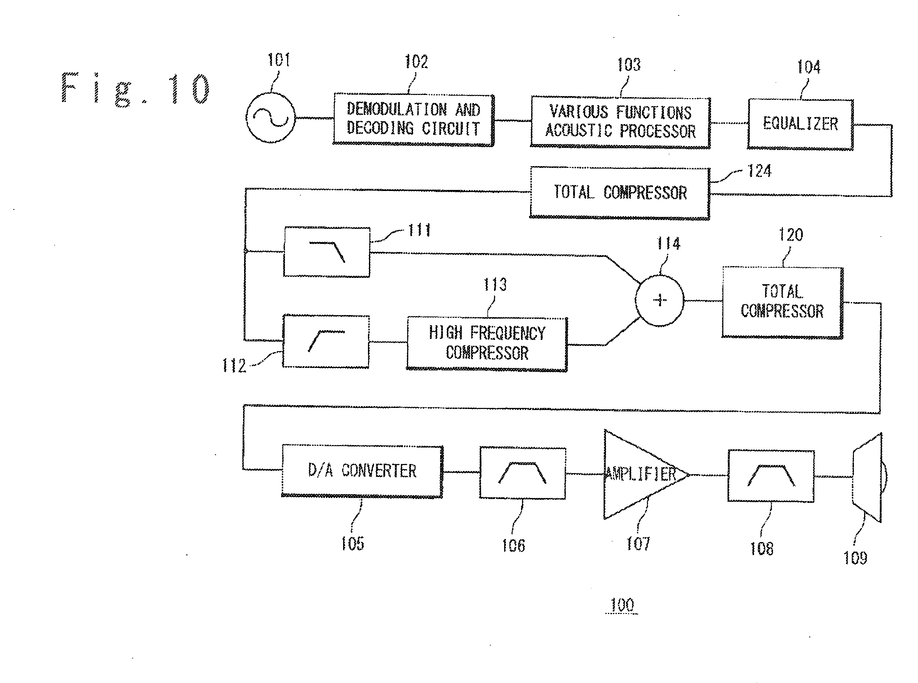

Fig. 10 is a block diagram showing a schematic configuration of a fourth modified example in the electronic apparatus acoustic processing system 100 shown in Fig. 3. Referring to Fig. 10, in the fourth modified example, the electronic apparatus acoustic processing system 100 has a total compressor 120 inserted between the adder 114 and the D/A converter 105, and further has a total compressor 124 inserted between the equalizer processor 104 and the low pass filter 111 as well as the high-pass filter 112. The remaining configuration is the same as that shown in Fig. 3.

The total compressor 124 compresses an input to the low pass filter 111 and the high-pass filter 112. By such a configuration, it is possible to compress the dynamic range for whole of the frequency band in an input to the low pass filter 111 and the high-pass filter 112. Consequently, it is possible to adjust parameters in wider range in each of the equalizer processor 104, the high frequency compressor 113 and the total compressor 120.

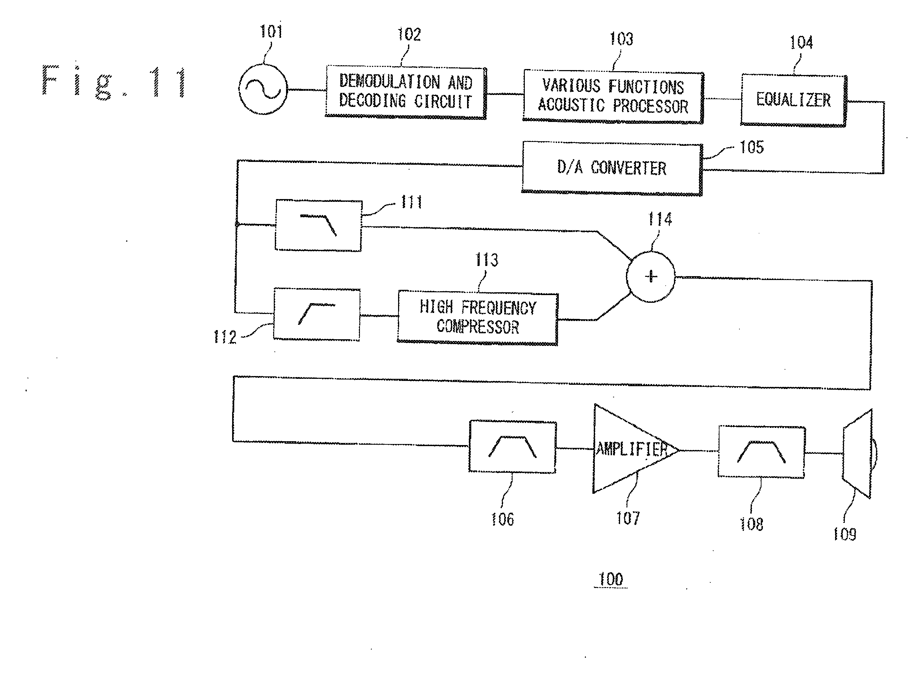

Fig. 11 is a block diagram showing a schematic configuration of a fifth modified example in the electronic apparatus acoustic processing system 100 shown in Fig. 3. Referring to Fig. 11, in the fifth modified example, a D/A converter 105 is inserted between the equalizer processor 104 and the low pass filter 111 as well as the high-pass filter 112. In this case, the low pass filter 111, the high-pass filter 112, the high frequency compressor 113 and the adder 114 in the fifth modified example carry out processes similar to the aforementioned processes with respect to an inputted analog signal.

The low pass filter 111, the high-pass filter 112 and the high frequency compressor 113 in the fifth modified example are arranged in a subsequent stage of the D/A converter 105 and serve as an audio path to carry out a dynamic range compressing process in a high frequency by analog. It is therefore possible to obtain effects similar to those of the electronic apparatus acoustic processing system 100 shown in Fig. 3.

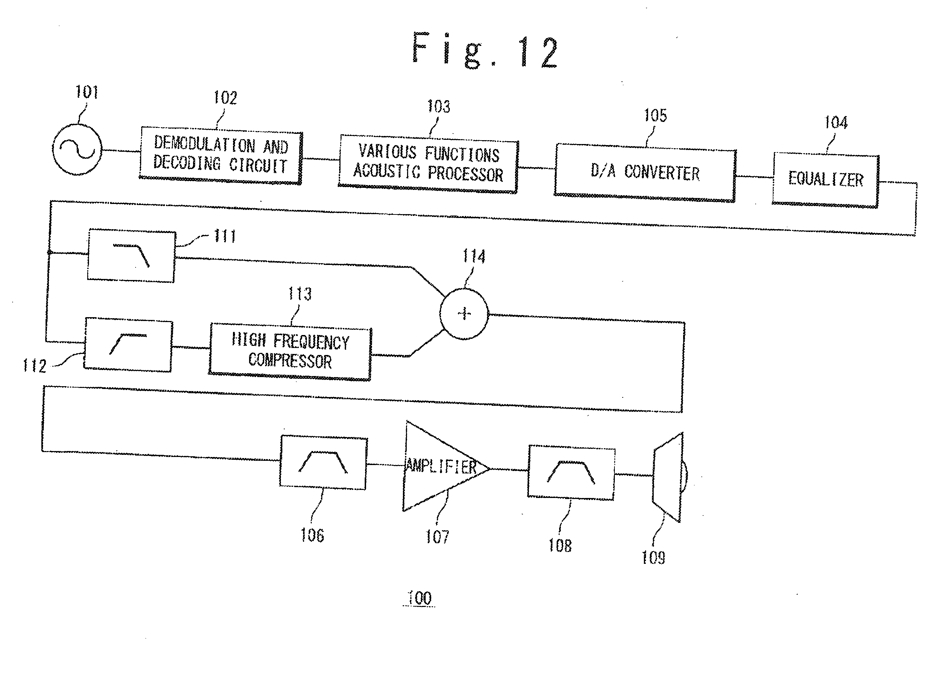

Fig. 12 is a block diagram showing a schematic configuration of a sixth modified example in the electronic apparatus acoustic processing system 100 shown in Fig. 3. Referring to Fig. 12, in the sixth modified example, a D/A converter 105 is inserted between the various functions acoustic processor 103 and the equalizer processor 104. In this case, the equalizer processor 104, the low pass filter 111, the high-pass filter 112, the high frequency compressor 113 and the adder 114 in the sixth example carry out a process similar to the aforementioned process with respect to an inputted analog signal.

The equalizer processor 104, the low pass filter 111, the high-pass filter 112, and the high frequency compressor 113 in the sixth modified example are arranged in a subsequent stage of the D/A converter 105 and serve as an audio path to carry out a dynamic range compressing process in a high frequency by analog. It is therefore possible to obtain effects similar to those of the electronic apparatus acoustic processing system 100 in the fourth modified example.

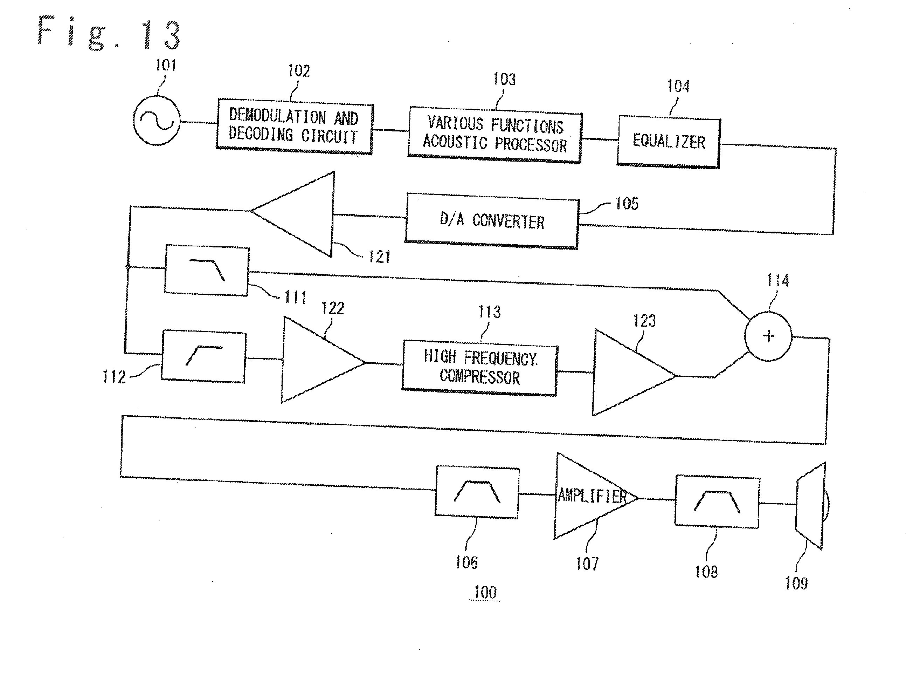

Fig. 13 is a block diagram showing a schematic configuration of a seventh modified example in the electronic apparatus acoustic processing system 100 shown in Fig. 3. Referring to Fig. 13, in the seventh modified example, a D/A converter 105 is inserted between the equalizer processor 104 and the low pass filter 111 as well as the high-pass filter 112. Pre-gain amplifiers 121, 122 and 123 of an analog type are further arranged. The pre-gain amplifier 121 is inserted between the D/A converter 105 and the low pass filter 111 as well as the high-pass filter 112. The pre-gain amplifier 122 is inserted between the high-pass filter 112 and the high frequency compressor 113. The pre-gain amplifier 123 is inserted between the high frequency compressor 113 and the adder 114. In this case, the low pass filter 111, the high-pass filter 112, the high frequency compressor 113, the adder 114, the pre-gain amplifiers 121 and 122, and the host gain amplifier 123 in the seventh modified example carry out a process similar to the aforementioned process with respect to an inputted analog signal.

By inserting the pre-gain amplifier 121, the pre-gain amplifier 122 and the host gain amplifier 123, it is possible to set the frequency gain in the same manner with the third modified example without using the equalizer processor 104.

As explained above, according to the present invention, even if a high frequency signal is boosted to be larger by the equalizer processor, only an excessive peak of a boosted high frequency signal is suppressed so that the dynamic range is compressed. Consequently, the average value of the signal level of the output signal is enhanced in comparison with the input signal in the time domain, along with enhancement of the executed sound pressure without changing the voltage peak inputted to a micro-speaker. Furthermore, a sound is generated by a signal which is obtained by adding a low frequency signal to a high frequency signal compressed by the high frequency compressor. Therefore, feeling of the sound volume is substantially enhanced with enhancement of an executed sound pressure.

Concrete configurations of the present invention are not limited to the exemplary embodiments described above in detail, and changes made in a range without deviating from the scope of the present invention are also included in the present invention.

## Claims

1. An acoustic processing system for an electronic apparatus comprising:
an equalizer processor (104) configured to boost or cut each frequency component of a digital signal having been acoustically processed;
a low-pass filter(111) configured to extract and output a signal of low frequency from the signal outputted from the equalizer processor;
a high-pass filter (112) configured to extract and output a signal of high frequency from the signal outputted from the equalizer processor;
a high frequency compressor (113) configured to compress the signal of high frequency;
an adder (114) configured to generate an addition of the signal of low frequency and the compressed signal of high frequency; and
a speaker (109) configure to output a sound in accordance with the addition signal; the low-pass filter (111) being directly connected to the adder (114).

2. The acoustic processing system for the electronic apparatus according to claim 1, further comprising:
a first total compressor (120) connected to the adder (114),
wherein the first total compressor is configured to compress the addition signal for a whole frequency band.

3. The acoustic processing system for the electronic apparatus according to claim 1, further comprising:
a storage device (115) configured to store a parameter table,
wherein a parameter for determining processing performance of each of the equalizer processor (104), the low-pass filter (111), the high path filter (112) and the high frequency compressor (113) is set in the parameter table.

4. The acoustic processing system for the electronic apparatus according to claim 1, further comprising:
a first pre-gain amplifier (121) inserted between: the equalizer processor (104); and the low-pass filter (111) and the high-pass filter (112);
a second pre-gain amplifier (122) inserted between the high-pass filter and the high frequency compressor (113); and
a host gain amplifier (123) inserted between the high frequency compressor and the adder (114).

5. The acoustic processing system for the electronic apparatus according to claim 1, further comprising:
a second total compressor (124) inserted between: the equalizer processor (104); and the low-pass filter (111) and the high-pass filter (112),
wherein the second total compressor is configured to compress an output signal from the equalizer processor to the low-pass filter and the high-pass filter for the whole frequency band.

6. The acoustic processing system for the electronic apparatus according to claim 1, further comprising:
a D/A converter (105) inserted between: the equalizer processor (104); and the low-pass filter (111) and the high-pass filter (112),
wherein the D/A converter is configured to convert an output signal from the equalizer processor into an analogue signal to output to the low-pass filter and the high-pass filter.

7. The acoustic processing system for the electronic apparatus according to claim 1, further comprising:
a D/A converter (105) arranged in a precedent stage of the equalizer processor (104),
wherein the D/A converter is configured to convert the digital signal being acoustically processed into an analogue signal to output to the equalizer processor, and
the equalizer processor is configure to boost or cut the analogue signal for each of frequency components.

8. The acoustic processing system for the electronic apparatus according to claim 1, further comprising:
a D/A converter (105) inserted between: the equalizer processor (104); and the low-pass filter (111) and the high-pass filter (112);
a first pre-gain amplifier (121) inserted between: the D/A converter; and the low-pass filter and the high-pass filter;
a second pre-gain amplifier (122) inserted between the high-pass filter and the high frequency compressor (113); and
a host gain amplifier (123) inserted between the high frequency compressor and the adder (114),
wherein the D/A converter is configured to convert an output signal from the equalizer processor into an analogue signal to output to the low-pass filter and the high-pass filter.

9. The acoustic processing system for the electronic apparatus according to claim 1, wherein the equalizer processor (104) is configured to cut a low frequency signal of the digital signal being acoustically processed under 500Hz at a maximum of 6 dB, and to boost a middle and high frequency signal of the digital signal being acoustically processed equal to or more than 500Hz at a maximum of 12 dB.

10. An acoustic processing method for an electronic apparatus comprising:
a step of boosting or cutting each frequency component of a digital signal with an equalizer processor, the digital signal having been acoustically processed;
a step of extracting and outputting a signal of low frequency from the boosted or cut signal with a low-pass filter;
a step of extracting and outputting a signal of a high frequency from the boosted or cut signal;
a step of compressing the signal of high frequency;
a step of generating an addition of the signal of low frequency and the compressed signal of high frequency with an adder; and
a step of outputting a sound in accordance with the addition signal; the low-pass filter being directly connected to the adder.

11. A mobile telephone terminal comprising the acoustic processing system according to any one of claims 1 to 10.

## Patentansprüche

1. Akustisches Verarbeitungssystem für eine elektronische Vorrichtung, umfassend:
einen Equalizerprozessor (104), der dazu eingerichtet ist, jede Frequenzkomponente eines digitalen Signals, welches akustisch verarbeitet wurde, zu verstärken oder herabzusetzen;
ein Tiefpassfilter (111), das dazu eingerichtet ist, ein Signal einer niedrigen Frequenz aus dem von dem Equalizerprozessor ausgegebenen Signal zu extrahieren und auszugeben;
ein Hochpassfilter (112), das dazu eingerichtet ist, ein Signal einer hohen Frequenz aus dem von dem Equalizerprozessor ausgegebenen Signal zu extrahieren und auszugeben;
einen Kompressor für hohe Frequenzen (113), der dazu eingerichtet ist, das Signal der hohen Frequenz zu komprimieren;
einen Addierer (114), der dazu eingerichtet ist, eine Addition des Signals der niedrigen Frequenz und des komprimierten Signals der hohen Frequenz zu erzeugen; und
einen Lautsprecher (109), der dazu eingerichtet ist, einen Schall in Übereinstimmung mit dem Additionssignal auszugeben; wobei das Tiefpassfilter unmittelbar mit dem Addierer verbunden ist.

2. Akustisches Verarbeitungssystem für die elektronische Vorrichtung nach Anspruch 1, femer umfassend:
einen ersten Gesamtkompressor (120), der mit dem Addierer (114) verbunden ist,
wobei der erste Gesamtkompressor dazu eingerichtet ist, das Additionssignal für ein gesamtes Frequenzband zu komprimieren.

3. Akustisches Verarbeitungssystem für die elektronische Vorrichtung nach Anspruch 1, femer umfassend:
ein Speichergerät (115), das dazu eingerichtet ist, eine Parametertabelle zu speichern,
wobei ein Parameter zum Bestimmen von Verarbeitungsleistung des Equalizerprozessors (104), des Tiefpassfilters (111), des Hochpassfilters (112) und des Kompressors für hohe Frequenzen (113) in der Parametertabelle festgesetzt ist.

4. Akustisches Verarbeitungssystem für die elektronische Vorrichtung nach Anspruch 1, femer umfassend:
einen ersten Vorverstärker (121), der eingefügt ist zwischen: dem Equalizerprozessor (104); und dem Tiefpassfilter (111) und dem Hochpassfilter (112);
einen zweiten Vorverstärker (122), der eingefügt ist zwischen dem Hochpassfilter und dem Kompressor für hohe Frequenzen (113); und
einen Hostverstärker (123), der eingefügt ist zwischen dem Kompressor für hohe Frequenzen und dem Addierer (114).

5. Akustisches Verarbeitungssystem für die elektronische Vorrichtung nach Anspruch 1, ferner umfassend:
einen zweiten Gesamtkompressor (124), der eingefügt ist zwischen: dem Equalizerprozessor (104); und dem Tiefpassfilter (111) und dem Hochpassfilter (112),
wobei der zweite Gesamtverstärker dazu eingerichtet ist, ein Ausgabesignal von dem Equalizerprozessor an das Tiefpassfilter und das Hochpassfilter für das gesamte Frequenzband zu komprimieren.

6. Akustisches Verarbeitungssystem für die elektronische Vorrichtung nach Anspruch 1, femer umfassend:
einen D/A-Konverter (105), der eingefügt ist zwischen: dem Equalizerprozessor (104); und dem Tiefpassfilter (111) und dem Hochpass6filter (112),
wobei der D/A-Konverter dazu eingerichtet ist, ein Ausgabesignal von dem Equalizerprozessor in ein analoges Signal zur Ausgabe an das Tiefpassfilter und das Hochpassfilter zu konvertieren.

7. Akustisches Verarbeitungssystem für die elektronische Vorrichtung nach Anspruch 1, ferner umfassend:
einen D/A-Konverter (105), der in einer vorangehenden Stufe des Equalizerprozessors (104) angeordnet ist,
wobei der D/A-Konverter dazu eingerichtet ist, das digitale Signal, welches akustisch verarbeitet wurde, in ein analoges Signal zur Ausgabe an den Equalizerprozessor umzuwandeln, und
der Equalizerprozessor dazu eingerichtet ist, das analoge Signal für jede Frequenzkomponente zu verstärken oder herabzusetzen.

8. Akustisches Verarbeitungssystem für die elektronische Vorrichtung nach Anspruch 1, ferner umfassend:
einen D/A-Konverter (105), der eingefügt ist zwischen: dem Equalizerprozessor (104); und dem Tiefpassfilter (111) und dem Hochpassfilter (112);
einen ersten Vorverstärker (121), der eingefügt ist zwischen: dem D/A-Konverter; und dem Tiefpassfilter und dem Hochpassfilter;
ein zweiter Vorverstärker (122), der eingefügt ist zwischen dem Hochpassfilter und dem Kompressor für hohe Frequenzen (113); und
einen Hostverstärker (123), der eingefügt ist zwischen dem Kompressor für hohe Frequenzen und dem Addierer (114),
wobei der D/A-Konverter dazu eingerichtet ist, ein Ausgabesignal von dem Equalizerprozessor in ein analoges Signal zur Ausgabe an das Tiefpassfilter und das Hochpassfilter umzuwandeln.

9. Akustisches Verarbeitungssystem für die elektronische Vorrichtung nach Anspruch 1, wobei der Equalizerprozessor (104) dazu eingerichtet ist, ein Signal einer niedrigen Frequenz des digitalen Signals, welches akustisch verarbeitet wurde, unter 500 Hz mit einem Maximum von 6 dB herabzusetzen und ein Signal einer mittleren und hohen Frequenz des digitalen Signals, welches akustisch verarbeitet wurde, gleich oder größer 500 Hz mit einem Maximum von 12 dB zu verstärken.

10. Akustisches Verarbeitungsverfahren für eine elektronische Vorrichtung, umfassend:
einen Schritt des Verstärkens oder Herabsetzens jeder Frequenzkomponente eines digitalen Signals mit einem Equalizerprozessor, wobei das digitale Signal akustisch verarbeitet wurde;
einen Schritt des Extrahierens und Ausgebens eines Signals einer niedrigen Frequenz aus dem verstärkten oder herabgesetzten Signal mit einem Tiefpassfilter;
einen Schritt des Extrahierens und Ausgebens eines Signals einer hohen Frequenz aus dem verstärkten oder herabgesetzten Signal;
einen Schritt des Komprimierens des Signals der hohen Frequenz;
einen Schritt des Erzeugens einer Addition des Signals der niedrigen Frequenz und des komprimierten Signals der hohen Frequenz mit einem Addierer; und
einen Schritt des Ausgebens eines Schalls in Übereinstimmung mit dem Additionssignal; wobei das Tiefpassfilter unmittelbar mit dem Addierer verbunden ist.

11. Mobiltelefonendgerät, umfassend das akustische Verarbeitungssystem nach einem der Ansprüche 1 bis 10.

## Revendications

1. Système de traitement acoustique pour un appareil électronique comprenant :
un processeur égalisateur (104) configuré pour amplifier ou couper chaque composante de fréquence d'un signal numérique ayant été traité acoustiquement ;
un filtre passe-bas (111) configuré pour extraire et produire en sortie un signal de basse fréquence du signal produit en sortie par le processeur égalisateur ;
un filtre passe-haut (112) configuré pour extraire et produire en sortie un signal de haute fréquence du signal produit en sortie par le processeur égalisateur ;
un compresseur haute fréquence (113) configuré pour compresser le signal de haute fréquence ;
un additionneur (114) configuré pour générer une addition du signal de basse fréquence et du signal compressé de haute fréquence ; et
un haut-parleur (109) configuré pour produire en sortie un son en conformité avec le signal d'addition ; le filtre passe-bas étant connecté directement à l'additionneur.

2. Système de traitement acoustique pour l'appareil électronique selon la revendication 1, comprenant en outre :
un premier compresseur total (120) connecté à l'additionneur (114),
dans lequel le premier compresseur total est configuré pour compresser le signal d'addition pour toute une bande de fréquence.

3. Système de traitement acoustique pour l'appareil électronique selon la revendication 1, comprenant en outre :
un dispositif de stockage (115) configuré pour stocker une table de paramètre,
dans lequel un paramètre permettant de déterminer une performance de traitement de chacun du processeur égalisateur (104), du filtre passe-bas (111), du filtre passe-haut (112) et du compresseur haute fréquence (113) est réglé dans la table de paramètre.

4. Système de traitement acoustique pour l'appareil électronique selon la revendication 1, comprenant en outre :
un premier préamplificateur de gain (121) inséré entre : le processeur égalisateur (104) ; et le filtre passe-bas (111) et le filtre passe-haut (112) ;
un second préamplificateur de gain (122) inséré entre le filtre passe-haut et le compresseur haute fréquence (113) ; et
un amplificateur de gain hôte (123) inséré entre le compresseur haute fréquence et l'additionneur (114).

5. Système de traitement acoustique pour l'appareil électronique selon la revendication 1, comprenant en outre :
un second compresseur total (124) inséré entre : le processeur égalisateur (104) ; et le filtre passe-bas (111) et le filtre passe-haut (112),
dans lequel le second compresseur total est configuré pour compresser un signal de sortie du processeur égalisateur au filtre passe-bas et au filtre passe-haut pour toute la bande de fréquence.

6. Système de traitement acoustique pour l'appareil électronique selon la revendication 1, comprenant en outre :
un convertisseur N/A (105) inséré entre : le processeur égalisateur (104) ; et le filtre passe-bas (111) et le filtre passe-haut (112),
dans lequel le convertisseur N/A est configuré pour convertir un signal de sortie du processeur égalisateur en un signal analogique à produire en sortie au filtre passe-bas et au filtre passe-haut.

7. Système de traitement acoustique pour l'appareil électronique selon la revendication 1, comprenant en outre :
un convertisseur N/A (105) agencé dans un étage précédent du processeur égalisateur (104),
dans lequel le convertisseur A/N est configuré pour convertir le signal numérique qui est traité acoustiquement en un signal analogique à produire en sortie vers le processeur égalisateur, et
le processeur égalisateur est configuré pour amplifier ou couper le signal analogique pour chacune des composantes de fréquence.

8. Système de traitement acoustique pour l'appareil électronique selon la revendication 1, comprenant en outre :
un convertisseur N/A (105) inséré entre : le processeur égalisateur (104) ; et le filtre passe-bas (111) et le filtre passe-haut (112) ;
un premier préamplificateur de gain (121) inséré entre : le convertisseur N/A ; et le filtre passe-bas et le filtre passe-haut ;
un second préamplificateur de gain (122) inséré entre le filtre passe-haut et le compresseur haute fréquence (113) ; et
un amplificateur de gain hôte (123) inséré entre le compresseur haute fréquence et l'additionneur (114),
dans lequel le convertisseur N/A est configuré pour convertir un signal de sortie du processeur égalisateur en un signal analogique à produire en sortie vers le filtre passe-bas et le filtre passe-haut.

9. Système de traitement acoustique pour l'appareil électronique selon la revendication 1, dans lequel le processeur égalisateur (104) est configuré pour couper un signal basse fréquence du signal numérique qui est traité acoustiquement à moins de 500 Hz à un maximum de 6 dB, et pour amplifier un signal de haute fréquence et de fréquence intermédiaire du signal numérique qui est traité acoustiquement à 500 Hz ou plus et à un maximum de 12 dB.

10. Procédé de traitement acoustique pour un appareil électronique comprenant :
une étape d'amplification ou de coupure de chaque composante de fréquence d'un signal numérique avec un processeur égalisateur, le signal numérique ayant été traité acoustiquement ;
une étape d'extraction et de production en sortie d'un signal de basse fréquence à partir du signal amplifié ou coupé avec un filtre passe-bas ;
une étape d'extraction et de production en sortie d'un signal de haute fréquence à partir du signal amplifié ou coupé ;
une étape de compression du signal de haute fréquence ;
une étape de génération d'une addition du signal de basse fréquence et du signal compressé de haute fréquence avec un additionneur ; et
une étape de production en sortie d'un son en conformité avec le signal d'addition ; le filtre passe-bas étant connecté directement à l'additionneur.

11. Terminal de téléphone mobile comprenant le système de traitement acoustique selon l'une quelconque des revendications 1 à 10.
